# EUROPEAN PATENT APPLICATION

(11) **EP 2 293 456 A2**
(43) Date of publication of application: **09.03.2011**
(21) Application number: 10170115.9
(22) Date of filing: 20.07.2010
(51) Int. Cl.: H04B 1/26

(54) **Receiver with re-demodulation**

(30) Priority: 03.09.2009 US 553101
(71) Applicant: Provigent Ltd., 46764 Herzlia (IL)
(72) Inventor: Friedmann, Jonathan, Tel Aviv (IL)
(74) Representative: Freeman, Avi

(57) **Abstract**

A receiver includes a front end, an up-converter and an interface. The front end is configured to down-convert a first Radio Frequency (RF) signal at a first frequency, so as to produce a second signal at a second frequency, lower than the first frequency. The up-converter is configured to up-convert the second signal to produce a third Intermediate Frequency (IF) signal at a third frequency, higher than the second frequency. The interface is configured to transmit the third signal over a cable for remote demodulation.

## Description

The present invention relates to a receiver. In embodiments, the present invention relates generally to radio communication systems, and particularly to methods and systems for performing frequency conversion in radio receivers.

Some communication systems, e.g., microwave links, partition the system circuitry between an Outdoor Unit (ODU) and an Indoor Unit (IDU). For example, U.S. Patent Application Publication 2005/0124307, whose disclosure is incorporated herein by reference, describes an indoor unit (IDU) and compact outdoor unit (ODU) having an intermediate frequency/modem circuit, millimeter wave transceiver circuit, and digital interface between the IDU and the ODU.

U.S. Patent 6,844,787, whose disclosure is incorporated herein by reference, describes a system that performs a first modulation at an arbitrary frequency and a second modulation at another arbitrary frequency. In order to achieve this goal, the system demodulates the first modulation using the same reference oscillator signal that was used in the first modulation. In effect, a first modulation is achieved at a first frequency, the first modulation is then demodulated to zero frequency, and, in turn, a second modulation is achieved at a second frequency.

An embodiment of the present invention provides a receiver, including:
a front end, which is configured to down-convert a first Radio Frequency (RF) signal at a first frequency, so as to produce a second signal at a second frequency, lower than the first frequency;
an up-converter, which is configured to up-convert the second signal to produce a third Intermediate Frequency (IF) signal at a third frequency, higher than the second frequency; and
an interface, which is configured to transmit the third signal over a cable for remote demodulation.

In some embodiments, the receiver further includes a reception subsystem, which is configured to receive the third signal from the cable, to down-convert the third signal and to demodulate the down-converted third signal. In an embodiment, the interface is operative to communicate a reference clock signal over the cable together with the third signal, the up-converter is configured to up-convert the second signal using the reference clock signal, and the reception subsystem is configured to down-convert the third signal using the reference clock signal. In a disclosed embodiment, the interface is configured to communicate management information over the cable between the receiver and the reception subsystem. In another embodiment, the receiver is included in an Outdoor Unit (ODU) and the reception subsystem is included in an Indoor Unit (IDU).

In yet another embodiment, the front end includes at least one filter, which is configured to filter the second signal and to provide the filtered second signal to the up-converter. In still another embodiment, the front end includes a frequency source, which is configured to generate at least one Local Oscillator (LO) signal, and the front end is configured to down-convert the first RF signal using the LO signal. In an embodiment, the second signal includes a baseband signal. In a disclosed embodiment, the front end is included in an integrated device, which is separate from the up-converter and is mounted in the receiver.

There is additionally provided, in accordance with an embodiment of the present invention, a method for communication, including:
down-converting a first Radio Frequency (RF) signal at a first frequency, so as to produce a second signal at a second frequency, lower than the first frequency;
up-converting the second signal to produce a third Intermediate Frequency (IF) signal at a third frequency, higher than the second frequency; and
transmitting the third signal over a cable for remote demodulation.

In an embodiment, the method comprises receiving the third signal from the cable, down-converting the third signal and demodulating the down-converted third signal.

In an embodiment, the method comprises communicating a reference clock signal over the cable together with the third signal, wherein up-converting the second signal comprises up-converting the second signal using the reference clock signal, and wherein down-converting the third signal comprises down-converting the third signal using the reference clock signal.

In an embodiment, the method comprises communicating management information over the cable together with the third signal.

In an embodiment, down-conversion of the first RF signal and up-conversion of the second signal are performed in an Outdoor Unit (ODU), and wherein down-conversion and demodulation of the third signal are performed in an Indoor Unit (IDU).

In an embodiment, the method comprises filtering the second signal prior to up-conversion of the second signal.

In an embodiment, the method comprises generating at least one Local Oscillator (LO) signal, wherein down-converting the first RF signal comprises down-converting the first RF signal using the LO signal.

In an embodiment, the second signal comprises a baseband signal.

In an embodiment, down-conversion of the first RF signal is performed by an integrated device that is separate from circuitry that up-converts the second signal.

There is also provided, in accordance with an embodiment of the present invention, a production method, including:
obtaining at least first and second identical front end units, which down-convert respective first Radio Frequency (RF) signals in a first frequency band to produce respective second signals in a second frequency band, lower than the first frequency band;
incorporating the first front end unit in a first receiver, which up-converts the second signal produced by the first front end unit to produce a third Intermediate Frequency (IF) signal in a third frequency band, higher than the second frequency band, transmits the third signal over a cable, receives the third signal from the cable, down-converts the third signal and demodulates the down-converted third signal; and
incorporating the second front end unit in a second receiver, which demodulates the second signal produced by the second front end unit.

There is also provided, in accordance with an embodiment of the present invention, a method, including:
producing at least first and second identical front end units, which down-convert respective first Radio Frequency (RF) signals in a first frequency band to produce respective second signals in a second frequency band, lower than the first frequency band;
supplying the first front end unit for use in a first receiver, which up-converts the second signal produced by the first front end unit to produce a third Intermediate Frequency (IF) signal in a third frequency band, higher than the second frequency band, transmits the third signal over a cable, receives the third signal from the cable, down-converts the third signal and demodulates the down-converted third signal; and
supplying the second front end unit for use in a second receiver, which demodulates the second signal produced by the second front end unit.

There is additionally provided, in accordance with an embodiment of the present invention, a production method, including:
obtaining at least first and second identical front end units, which down-convert respective first Radio Frequency (RF) signals in a first frequency band to produce respective second Intermediate Frequency (IF) signals in a second frequency band, lower than the first frequency band;
incorporating the first front end unit in a first receiver, which transmits the second signal produced by the first front end unit over a cable, receives the second signal transmitted over the cable, down-converts the received second signal and demodulates the down-converted second signal; and
incorporating the second front end unit in a second receiver, which demodulates the second signal produced by the second front end unit using circuitry that is collocated with the second front end unit.

There is also provided, in accordance with an embodiment of the present invention, a method, including:
producing at least first and second identical front end units, which down-convert respective first Radio Frequency (RF) signals in a first frequency band to produce respective second Intermediate Frequency (IF) signals in a second frequency band, lower than the first frequency band;
supplying the first front end unit for use in a first receiver, which transmits the second signal produced by the first front end unit over a cable, receives the second signal transmitted over the cable, down-converts the received second signal and demodulates the down-converted second signal; and
supplying the second front end unit for use in a second receiver, which demodulates the second signal produced by the second front end unit using circuitry that is collocated with the second front end unit.

The present invention will be more fully understood from the following detailed description of the embodiments thereof, taken together with the drawings in which:

### BRIEF DESCRIPTION OF THE DRAWINGS

Figs. 1 and 2 are block diagrams that schematically illustrate receivers, in accordance with embodiments of the present invention;
Fig. 3 is a flow chart that schematically illustrates a method for reception, in accordance with an embodiment of the present invention;
Fig. 4 is a flow chart that schematically illustrates a method for manufacturing receivers, in accordance with an embodiment of the present invention; and
Figs. 5A and 5B are block diagrams that schematically illustrate receivers, in accordance with alternative embodiments of the present invention.

### DETAILED DESCRIPTION OF EMBODIMENTS

### OVERVIEW

Some radio communication systems use split-mount configurations, in which a Radio Frequency (RF) front end is mounted in an Outdoor Unit (ODU), a modem is mounted in an Indoor Unit (IDU), and the ODU and IDU are connected by a cable. Other communication systems use single-mount configurations, in which both the RF front end and the modem are mounted in a single enclosure.

Embodiments of the present invention that are described hereinbelow provide improved receiver designs, which enable the use of a common RF front end unit type for both split-mount and single-mount system configurations. In some embodiments, the RF front end unit receives an RF signal and down-converts it to a low frequency, typically to baseband. In a single-mount configuration, the receiver comprises a demodulator, which demodulates the signal produced by the RF front end unit. In a split-mount configuration, on the other hand, the low-frequency output of the front end unit is up-converted to IF and then sent over the cable for remote demodulation. In alternative embodiments, the RF front end unit produces an Intermediate Frequency (IF) signal. In a split-mount configuration, the IF signal produced by the front end unit is sent over the cable. In a single-mount configuration, the IF signal is demodulated in the ODU, e.g., using additional down-conversion or direct IF sampling.

The receiver designs described herein enable equipment manufacturers to handle (e.g., specify, design, buy, produce, stock, test, integrate, install, operate and/or troubleshoot) only a single type of RF front end unit, and to use these front end units in both split-mount and single-mount system configurations. As a result, manufacturing and stocking costs are reduced.

### SYSTEM DESCRIPTION

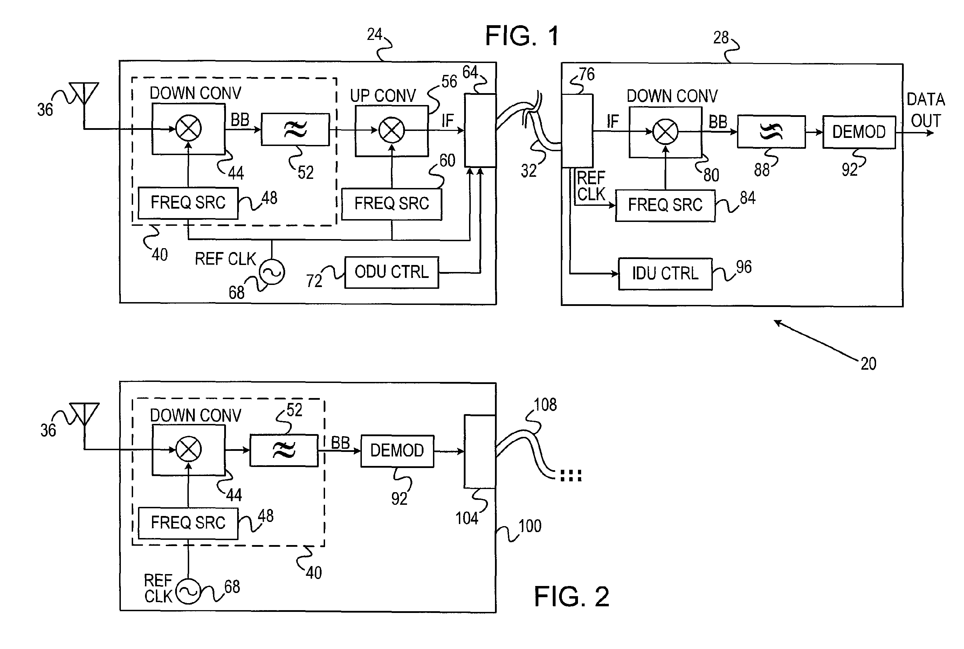

Fig. 1 is a block diagram that schematically illustrates a receiver 20, in accordance with an embodiment of the present invention. A receiver of this sort can be used, for example, in a point-to-point microwave or millimeter-wave communication link, or in any other suitable communication system. (Figs. 1 and 2 show only reception-related elements, although a typical communication system usually comprises transmitter elements, as well. Since the methods and systems described herein are primarily concerned with signal reception, transmitter elements are not shown in the figures.)

Receiver 20 comprises an Outdoor Unit (ODU) 24 and an Indoor Unit (IDU) 28, which are connected to one another by a cable 32, e.g., a coaxial cable or other suitable transmission line. This system configuration is referred to herein as a split-mount configuration. A Radio Frequency (RF) signal is received by a receive antenna 36 and provided to ODU 24. Receiver 20 may be designed to receive RF signals in any suitable frequency band, such as various licensed and unlicensed frequency bands specified by the European Telecommunications Standards Institute (ETSI) in the 6-40 or 60-80 GHz range. Specific frequency bands can be selected, for example, in the 7, 11, 13, 15, 18, 23, 26, 28, 32 or 38 GHz bands. The RF signal is transmitted to receiver 20 by a remote transmitter (not shown). The RF signal is modulated with data that is to be demodulated and extracted by the receiver.

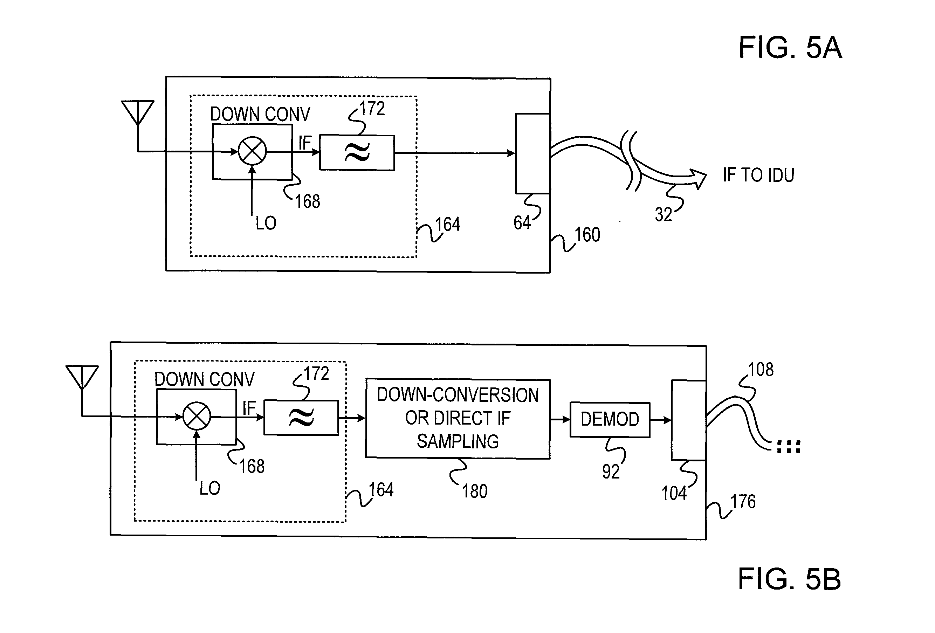

ODU 24 comprises an RF front end unit 40, which down-converts the received RF signal to low frequency, typically to baseband. As will be shown below, front end 40 is a common building block that is used in both split-mount and single-mount system configurations. An alternative configuration, which uses a common front end that produces an IF signal, is shown in Figs. 5A and 5B further below. In the present example, front end unit 40 down-converts the RF signal in a single down-conversion operation. In alternative embodiments, however, common front end units that perform multiple down-conversion operations can also be used.

Front end 40 comprises a down-converting mixer 44 and a frequency source 48 (e.g., a Phase-Locked Loop - PLL). (In a typical implementation, front end 40 may comprise additional components and functions, which are not related to carrying out the disclosed techniques. These elements are not shown in the figures for the sake of clarity.) Frequency source 48 generates a suitable Local Oscillator (LO) signal and provides it to mixer 44. The mixer down-converts the RF signal by mixing it with the LO signal. In some embodiments, front end 40 comprises a low-pass filter 52, which filters the output of mixer 44 so as to suppress out-of-band signals. Thus, front end unit 40 produces a baseband signal that is ready for baseband processing by a demodulator.

As will be shown in Fig. 2 below, in single-mount configurations the output of front end 40 is provided directly to a demodulator. In the split-mount configuration of Fig. 1, however, the demodulator resides in IDU 28, and therefore the baseband signal is to be sent over cable 32 to the IDU. For this purpose, ODU 24 comprises an up-converting mixer 56, which up-converts the baseband signal to a suitable Intermediate Frequency (IF). (Transmission of IF signals over the cable is usually preferable to transmission of baseband signals, for example because it eliminates the need to perform echo cancellation, and enables reserving the baseband frequencies for transferring control signals between the ODU and IDU.)

Although it is possible in principle to down-convert the RF signal to IF without going through baseband, down-conversion to baseband enables both split-mount and single-mount receiver configurations to use a common RF front end design. It is also possible in principle to down-convert the RF signal to IF using double conversion, use the IF signal in split-mount configurations, and use additional down-conversion or direct IF sampling in single-mount configuration. This solution, however, is relatively complex and has high cost, size and power consumption.

Mixer 56 thus produces an IF signal, at a frequency that is higher than the frequency of the signal produced by front end 40. The frequency of the IF signal can be set to any suitable value, such as, for example, 140MHz. Mixer 56 up-converts the baseband signal by mixing it with a suitable LO signal provided by a frequency source 60, e.g., a PLL. The ODU may comprise a filter (e.g., band-pass or low-pass filter, not shown) for filtering the IF output of mixer 56, as well as various other components such as amplifiers and n-plexers. The IF signal is provided to a cable interface 64, which sends the signal over cable 32 to the IDU.

IDU 28 comprises a cable interface 76, which receives the IF signal from cable 32. The IDU comprises a down-converting mixer 80, which down-converts the IF signal to low frequency (e.g., baseband). Mixer 80 down-converts the IF signal by mixing it with a LO signal produced by a frequency source 84, e.g., a PLL. The signal produced by mixer 80 is filtered by a low-pass filter 88 and provided to a demodulator 92. The demodulator demodulates the baseband signal so as to extract the data. The data is provided as output to a user or host system (not shown). In an alternative embodiments, IDU 28 may demodulate the IF signal using direct IF sampling instead of down-converting it to baseband.

Each of the frequency sources in the ODU and IDU generates an LO signal that is locked to a certain reference clock signal. Any suitable clock frequency, such as 10, 40 or 100 MHz, can be used.

In some embodiments, frequency source 60 in the ODU and frequency source 84 in the IDU generate LO signals that are locked to a common reference clock signal. In other words, up-conversion from baseband to IF in the ODU, and down-conversion from IF back to baseband in the IDU, are performed using LO signals that are locked to the same reference clock signal. Performing up- and down-conversion using the same reference clock signal improves the receiver performance, e.g., reduces frequency offsets and combines I/Q imbalances to allow easier compensation by the host. Receiver 20 comprises a reference clock generator 68, which generates the common reference clock signal. In the example of Fig. 1, frequency source 48 is also locked to the common reference clock signal, although this configuration is not mandatory.

When both ODU and IDU use the same reference clock signal, the signal is transferred over cable 32. In the example embodiment of Fig. 1, generator 68 resides in ODU 24, and the common reference clock signal is sent over cable 32 to IDU 28. Alternatively, however, generator 68 may equivalently reside in the IDU. In these embodiments, the common reference clock signal is sent over the cable to the ODU. In either case, cable interfaces 64 and 76 multiplex and de-multiplex the reference clock signal with the IF signal over cable 32.

In some embodiments, ODU 24 and IDU 28 may exchange management data with one another over cable 32. In the example of Fig. 1, ODU 24 comprises an ODU controller 72, and IDU 28 comprises an IDU controller 96. Controllers 72 and 96 exchange management data with one another by communicating over cable 32. Cable interfaces 64 and 76 multiplex and de-multiplex the management data with the IF signal, and possibly with the common reference clock signal, over cable 32. In an embodiment, cable interfaces 64 and 76 may comprise dedicated modems, which modulate and demodulate the management data for transmission over the cable. Any suitable modulation, such as baseband Amplitude Shift Keying (ASK), can be used for this purpose.

Fig. 2 is a block diagram that schematically illustrates a receiver 100, in accordance with an embodiment of the present invention. Unlike the split-mount configuration of receiver 20 shown in Fig. 1 above, receiver 100 has a single-mount configuration in which the RF front end and the demodulator are collocated in a single enclosure. Typically although not necessarily, this single enclosure is located adjacently to antenna 36.

In receiver 100, an RF signal is received by antenna 36 and down-converted to baseband by RF front end 40, similarly to the operation of receiver 20 of Fig. 1 above. In the single-mount configuration of receiver 100, however, the baseband output of RF front end 40 is provided directly to demodulator 92. The demodulated data is sent by a cable interface 104 to a user or host system over a cable 108. In the configuration of Fig. 2, cable interface 104 outputs digital data according to a certain protocol (e.g., Ethernet), and cable 108 comprises a cable suitable for digital communication, such 10BaseT, 100BaseT or Gigabit Ethernet.

As can be seen in the figure, receiver 100 uses the same type of RF front end unit 40 used in receiver 20. Since demodulator 92 is collocated with RF front end 40, the signals sent over cable 108 are digital. Thus, baseband-to-IF up-conversion and IF-to-baseband down-conversion are eliminated.

The configurations of receivers 20 and 100 are example configurations, which were chosen purely for the sake of conceptual clarity. In alternative embodiments, any other suitable configuration can also be used. For example, in a split-mount configuration, the ODU and IDU may generate separate reference clock signals instead of transferring a common reference clock signal over the cable. Additionally or alternatively, the receiver may use separate cables for transferring the received (IF) signal, clock signals and/or management data. RF front end 40 may comprise any other suitable down-conversion circuitry. For example, the RF front end may comprise two or more mixers that down-convert the received RF signal in multiple conversions instead of performing direct conversion to baseband.

The different elements of receivers 20 and 100 may be implemented using discrete components, Radio Frequency Integrated Circuits (RFICs), Monolithic Microwave Integrated Circuits (MMICs) or any other suitable hardware. In particular, front end 40 may be fabricated in an integrated device or unit, which can be mounted in both split-mount and single-mount receivers. The term "integrated device" refers to any kind of package, board or other means of fabricating and assembling the elements of front end 40. For example, the front end can be fabricated in a dedicated IC (e.g., an RFIC or MMIC), or on a dedicated Printed Circuit Board (PCB) or other substrate.

### RECEPTION METHOD DESCRIPTION

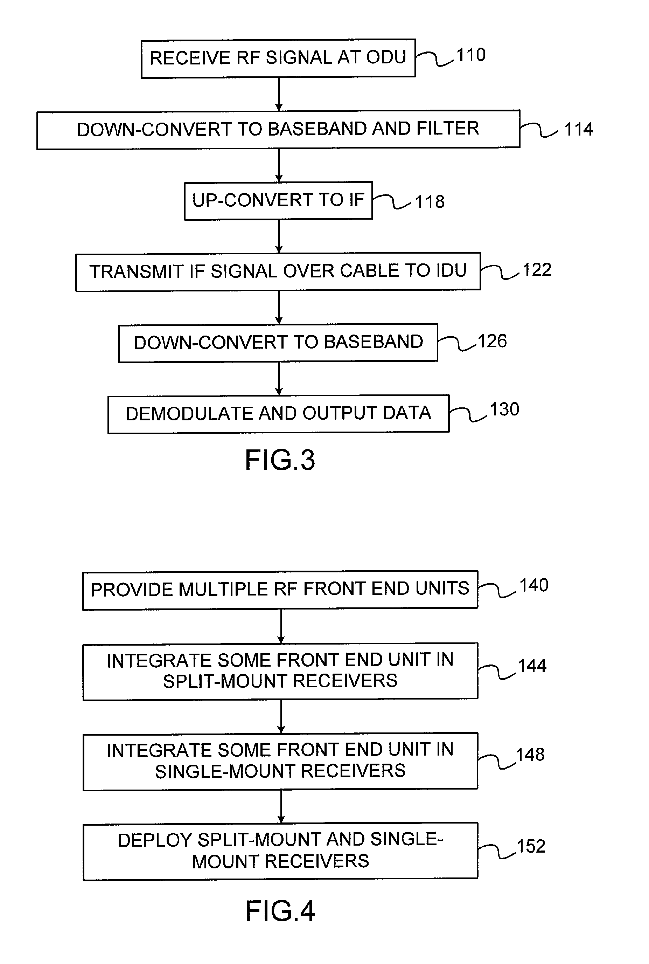

Fig. 3 is a flow chart that schematically illustrates a method for reception, carried out by receiver 20 of Fig. 1 above, in accordance with an embodiment of the present invention. The method begins with antenna 36 of ODU 24 receiving an RF signal, at a reception step 110. RF front end 40 down-converts the RF signal to baseband or low IF and filters the down-converted signal, at a first down-conversion step 114. Mixer 56 up-converts the baseband signal to IF, at an up-conversion step 118.

Cable interface 64 sends the IF signal over cable 32 to IDU 28, at a cable transmission step 122. Cable interface 76 in the IDU receives the IF signal from the cable. In some embodiments, cable interfaces 64 and 76 multiplex and de-multiplex a common reference clock signal and/or management data over the cable, together with the IF signal.

In the IDU, mixer 80 down-converts the IF signal received over the cable to baseband, at a second down-conversion step 126. Filter 88 filters the down-converted signal. Demodulator 92 demodulates the baseband signal produced by mixer 80, at a demodulation step 130. The demodulated data is provided as output.

### RECEIVER PRODUCTION USING COMMON RF FRONT END UNIT TYPE

As noted above, the disclosed receiver configurations enable a receiver manufacturer to manufacture both split-mount and single-mount receivers using the same type of RF front end unit. In a possible manufacturing process, a device manufacturer produces multiple front end units (e.g., in RFICs). The device manufacturer may supply the front end units to one or more system integrators (e.g., receiver manufacturers) for use in both split-mount and single-mount receiver configurations.

Fig. 4 is a flow chart that schematically illustrates a method for manufacturing receivers, in accordance with an embodiment of the present invention. The method begins with the manufacturer obtaining multiple RF front end units, e.g., units 40 of Figs. 1 and 2 above, at a front end providing step 140. The manufacturer may produce, integrate, acquire or otherwise obtain the RF front end units as input to the receiver production process. The manufacturer produces one or more split-mount receivers, such as receiver 20 of Fig. 1 above, using RF front end units 40, at a split-mount production step 144. In addition, the manufacturer produces one or more single-mount receivers, such as receiver 100 of Fig. 2 above, using RF front end units 40, at a single-mount production step 148. Both types of receivers can then be deployed, e.g., by a system integrator or service provider, at a deployment step 152.

### ALTERNATIVE COMMON RF FRONT END CONFIGURATION

In some embodiments, both split-mount and single-mount receivers are constructed using a common type of RF front end unit, which down-converts the received RF signal to IF. In split-mount configurations, the IF signal produced by the front end is sent over the cable to the IDU for remote demodulation. In single-mount configurations, the IF signal is demodulated locally (i.e., using circuitry that is collocated with the front end in the ODU). Demodulation of the IF signal in the ODU may be performed, for example, using an additional down-conversion or using direct IF sampling.

Figs. 5A and 5B are block diagrams that schematically illustrate split-mount and single-mount receiver configurations, respectively, in accordance with embodiments of the present invention. Both receiver configurations use a common type of RF front end unit, which produces IF output. Figs. 5A and 5B are simplified block diagrams, in which various receiver elements (e.g., frequency sources, reference clock sources and controllers as shown in Figs. 1 and 2 above) have been omitted for the sake of clarity.

Fig. 5A shows an ODU 160 used in a split-mount receiver configuration, in accordance with an embodiment of the present invention. ODU 160 comprises a front end unit 164. The same type of front end unit is also used in the single-mount configuration of Fig. 5B below. In the split-mount configuration of Fig. 5A, the received RF signal is provided to front end unit 164. The front end unit comprises a down-converting mixer 168, which down-converts the RF signal to IF (e.g., to 140MHz) by mixing it with an LO signal produced by a frequency source (not shown). Front end 164 down-converts the RF signal to IF in a single conversion operation. In alternative embodiments, common front end units that perform multiple down-conversion operations can also be used.

The front end may also comprise an IF filter 172 (e.g., a low-pass or band-pass filter), which filters out undesired signals. The IF signal produced by front end unit 164 is provided to cable interface 64, which sends the signal over cable 32 to the IDU. Any suitable split-mount IDU, such as IDU 28 of Fig. 1 above, can be used to demodulate and extract the data from the IF signal sent over the cable.

Fig. 5B shows an ODU 176 used in a single-mount receiver configuration, in accordance with an embodiment of the present invention. In ODU 176, the RF signal is down-converted to IF and filtered by the same type of front end unit 164 used in ODU 160 of Fig. 5A. The IF signal is then processed by an IF processing unit 180. In some embodiments, unit 80 comprises a down-converter (e.g., a down-converting mixer and possibly other elements such as filters and amplifiers), which down-converts the IF signal to baseband. Alternatively, unit 180 may comprise circuitry (e.g., one or more analog-to-digital converters) that performs direct IF sampling of the IF signal. The output of unit 180 is provided to demodulator 92, which demodulates the signal and extracts the data. The extracted data is then sent using cable interface 104 to a user or host system over cable 108.

The split-mount and single-mount receivers of Figs. 5A and 5B can be manufactured in any suitable process, such as the process described in Fig. 4 above.

Although the embodiments described herein mainly address the design of split-mount and single-mount receivers using a common type of RF front end, the methods and systems described herein can also be used in various other applications.

It will thus be appreciated that the embodiments described above are cited by way of example, and that the present invention is not limited to what has been particularly shown and described hereinabove. Rather, the scope of the present invention includes both combinations and sub-combinations of the various features described hereinabove, as well as variations and modifications thereof which would occur to persons skilled in the art upon reading the foregoing description and which are not disclosed in the prior art.

## Claims

1. A receiver, comprising:
a front end, which is configured to down-convert a first Radio Frequency (RF) signal at a first frequency, so as to produce a second signal at a second frequency, lower than the first frequency;
an up-converter, which is configured to up-convert the second signal to produce a third Intermediate Frequency (IF) signal at a third frequency, higher than the second frequency; and
an interface, which is configured to transmit the third signal over a cable for remote demodulation.

2. The receiver according to claim 1, and comprising a reception subsystem, which is configured to receive the third signal from the cable, to down-convert the third signal and to demodulate the down-converted third signal.

3. The receiver according to claim 1 or claim 2, wherein the interface is operative to communicate a reference clock signal over the cable together with the third signal, wherein the up-converter is configured to up-convert the second signal using the reference clock signal, and wherein the reception subsystem is configured to down-convert the third signal using the reference clock signal.

4. The receiver according to any of claims 1 to 3, wherein the interface is configured to communicate management information over the cable between the receiver and the reception subsystem.

5. The receiver according to any of claims 1 to 4, wherein the receiver is comprised in an Outdoor Unit (ODU) and wherein the reception subsystem is comprised in an Indoor Unit (IDU).

6. The receiver according to any of claims 1 to 5, wherein the front end comprises at least one filter, which is configured to filter the second signal and to provide the filtered second signal to the up-converter.

7. The receiver according to any of claims 1 to 6, wherein the front end comprises a frequency source, which is configured to generate at least one Local Oscillator (LO) signal, and wherein the front end is configured to down-convert the first RF signal using the LO signal.

8. The receiver according to any of claims 1 to 7, wherein the second signal comprises a baseband signal.

9. The receiver according to any of claims 1 to 8, wherein the front end is comprised in an integrated device, which is separate from the up-converter and is mounted in the receiver.

10. A method for communication, comprising:
down-converting a first Radio Frequency (RF) signal at a first frequency, so as to produce a second signal at a second frequency, lower than the first frequency;
up-converting the second signal to produce a third Intermediate Frequency (IF) signal at a third frequency, higher than the second frequency; and
transmitting the third signal over a cable for remote demodulation.

11. The method according to claim 10, and comprising receiving the third signal from the cable, down-converting the third signal and demodulating the down-converted third signal.

12. A production method, comprising:
obtaining at least first and second identical front end units, which down-convert respective first Radio Frequency (RF) signals in a first frequency band to produce respective second signals in a second frequency band, lower than the first frequency band;
incorporating the first front end unit in a first receiver, which up-converts the second signal produced by the first front end unit to produce a third Intermediate Frequency (IF) signal in a third frequency band, higher than the second frequency band, transmits the third signal over a cable, receives the third signal from the cable, down-converts the third signal and demodulates the down-converted third signal; and
incorporating the second front end unit in a second receiver, which demodulates the second signal produced by the second front end unit.

13. A method, comprising:
producing at least first and second identical front end units, which down-convert respective first Radio Frequency (RF) signals in a first frequency band to produce respective second signals in a second frequency band, lower than the first frequency band;
supplying the first front end unit for use in a first receiver, which up-converts the second signal produced by the first front end unit to produce a third Intermediate Frequency (IF) signal in a third frequency band, higher than the second frequency band, transmits the third signal over a cable, receives the third signal from the cable, down-converts the third signal and demodulates the down-converted third signal; and
supplying the second front end unit for use in a second receiver, which demodulates the second signal produced by the second front end unit.

14. A production method, comprising:
obtaining at least first and second identical front end units, which down-convert respective first Radio Frequency (RF) signals in a first frequency band to produce respective second Intermediate Frequency (IF) signals in a second frequency band, lower than the first frequency band;
incorporating the first front end unit in a first receiver, which transmits the second signal produced by the first front end unit over a cable, receives the second signal transmitted over the cable, down-converts the received second signal and demodulates the down-converted second signal; and
incorporating the second front end unit in a second receiver, which demodulates the second signal produced by the second front end unit using circuitry that is collocated with the second front end unit.

15. A method, comprising:
producing at least first and second identical front end units, which down-convert respective first Radio Frequency (RF) signals in a first frequency band to produce respective second Intermediate Frequency (IF) signals in a second frequency band, lower than the first frequency band;
supplying the first front end unit for use in a first receiver, which transmits the second signal produced by the first front end unit over a cable, receives the second signal transmitted over the cable, down-converts the received second signal and demodulates the down-converted second signal; and
supplying the second front end unit for use in a second receiver, which demodulates the second signal produced by the second front end unit using circuitry that is collocated with the second front end unit.
